# EUROPÄISCHE PATENTSCHRIFT

(11) **EP 0 914 676 B1**
(45) Veröffentlichungstag und Bekanntmachung des Hinweises auf die Patenterteilung: **10.05.2006**
(21) Anmeldenummer: 98924075.9
(22) Anmeldetag: 24.03.1998
(51) Int. Cl.: H01L 21/00

(54) **BAUTEIL AUS QUARZGLAS FÜR DIE VERWENDUNG BEI DER HALBLEITERHERSTELLUNG**
QUARTZ GLASS COMPONENT USED IN THE PRODUCTION OF SEMICONDUCTORS
ELEMENT EN VERRE DE QUARTZ S'UTILISANT DANS LA PRODUCTION DE SEMI-CONDUCTEURS

(30) Priorität: 27.03.1997 DE 19713014
(43) Veröffentlichungstag der Anmeldung: 12.05.1999
(73) Patentinhaber: Heraeus Quarzglas GmbH & Co. KG, 63450 Hanau (DE); Heraeus S.A.S., 91945 Courtaboeuf (FR)
(72) Erfinder: HELLMANN, Dietmar, D-63589 Linsengericht (DE); LEBRUN, Gérard, F-38500 Coublevie (FR); BECKER, Jörg, D-61194 Niddatal 4 (DE)
(74) Vertreter: Kühn, Hans-Christian
(86) Internationale Anmeldenummer: PCT/EP1998/001715
(87) Internationale Veröffentlichungsnummer: WO 1998/044538

(56) Entgegenhaltungen:
- EP-A- 0 444 809
- EP-A- 0 763 504
- US-A- 4 797 316
- US-A- 5 614 071
- DATABASE WPI Section Ch, Week 9835 Derwent Publications Ltd., London, GB; Class L01, AN 98-408418 XP002080127 -& JP 10 167760 A (HITACHI HOKKAI SEMICONDUCTOR), 23. Juni 1998
- PATENT ABSTRACTS OF JAPAN vol. 016, no. 435 (E-1263), 10. September 1992 -& JP 04 152515 A (SEIKO EPSON CORP), 26. Mai 1992 -& DATABASE WPI Week 9227 Derwent Publications Ltd., London, GB; AN 92-223935 XP002080120 & JP 00 415215 A
- PATENT ABSTRACTS OF JAPAN vol. 004, no. 185 (E-038), 19. Dezember 1980 & JP 55 127021 A (MITSUBISHI ELECTRIC CORP), 1. Oktober 1980
- PATENT ABSTRACTS OF JAPAN vol. 008, no. 049 (E-230), 6. März 1984 & JP 58 202535 A (HITACHI SEISAKUSHO KK), 25. November 1983
- DATABASE WPI Week 9606 12. Mai 1995 (1995-05-12), Derwent Publications Ltd., London, GB; AN 1996-055754 SHINETSU QUARTZ PROD: "Surface treatment of quartz glass" & JP 07 315872 A
- DATABASE WPI Week 9550 17. Oktober 1995 (1995-10-17), Derwent Publications Ltd., London, GB; AN 1995-390082 SHINETSU QUARTZ PROD: "Surface treating soln. for silica glass" & JP 07 267679 A

## Beschreibung

Die Erfindung betrifft ein Bauteil aus Quarzglas für die Verwendung bei der Halbleiterherstellung, mit einer rauhen Oberfläche, die durch unregelmäßige, erhabene Strukturelemente gebildet wird, die sich zwischen einer ersten, höheren Ebene und einer zweiten, tieferen Ebene erstrecken, wobei eine Vielzahl der Strukturelemente eine in der ersten Ebene verlaufende, im wesentlichen ebene Deckfläche aufweist, die allseitig facettenartig von im wesentlichen ebenen Seitenflächen begrenzt ist, die zwischen der ersten und der zweiten Ebene verlaufen.

Bei der Herstellung von Halbleiterbauelementen sind Substrat-Beschichtungen unter Verwendung sogenannter CVD-Verfahren üblich. So werden beispielsweise auf Silizium-Wafern Schichten aus Siliziumoxid, Siliziumnitrid oder aus Silizium abgeschieden. Dabei schlagen sich die Beschichtungsmaterialien aber nicht nur auf dem Substrat, sondern auch auf den Wandungen des Reaktionsraumes und auf den darin angeordneten Gerätschaften nieder. Ab einer gewissen Schichtdicke platzen diese Schichten ab und führen so zu Partikelproblemen. Um dies zu verhindern, werden die entsprechenden Oberflächen von Zeit zu Zeit gereinigt.

Das Reinigen der Oberflächen ist zeit- und kostenaufwendig. Um diesen Aufwand zu verringern, sind möglichst lange Zeitintervalle zwischen aufeinanderfolgenden Reinigungsschritten erwünscht. Insbesondere bei CVD-Verfahren bei höheren Temperaturen führt der Unterschied zwischen den thermischen Ausdehnungskoeffizienten von Quarzglas und dem Beschichtungsmaterial jedoch bereits bei relativ geringen Schichtdicken zum Abplatzen der Schichten.

Es ist bekannt, daß aufgerauhte Oberflächen dickere CVD-Schichten halten können. Zum Aufrauhen von Quarzglas-Bauteilen werden üblicherweise Sandstrahlverfahren oder chemische Ätzverfahren eingesetzt. Durch das Sandstrahlen werden auf der Quarzglas-Oberfläche zwar Strukturen erzeugt, die einerseits zu einer festeren Haftung von CVD-Schichten beitragen, andererseits werden dadurch aber Risse in der Bauteil-Oberfläche induziert, die wiederum zu einem Abblättern der CVD-Schichten führen. Darüberhinaus erweist sich eine homogene Bearbeitung der gesamten Oberfläche eines Bauteils und die Einhaltung exakter Dimensionen beim Sandstrahlen als problematisch.

Alternativ werden die Bauteil-Oberflächen aus Quarzglas durch chemische Ätzlösungen aufgerauht. Durch Anätzen Oberfläche werden häufig abgerundete Oberflächenstrukturen, beispielsweise runde oder ovale Grübchen erzeugt. Derartige Oberflächenstrukturen weisen sich im Vergleich zu der sandgestrahlten Oberfläche eine verminderten Haftfestigkeit für CVD-Schichten auf.

Ein Bauteil gemäß der angegebenen Gattung ist in der veröffentlichten japanischen Patentanmeldung JP 7-315872 (Anmelde-Nr. JP 6-332956) beschrieben. Daraus ist eine Ätzlösung zum Aufrauhen von Quarzglas-Oberflächen bekannt, mittels der unregelmäßige, erhabene, im wesentlichen scharfkantige Strukturelemente auf einer Bauteiloberfläche aus Quarzglas erzeugt werden können. In der Draufsicht auf eine mit der bekannten Ätzlösung bearbeitete Oberfläche ist eine körnige Morphologie mit einer Aneinanderreihung von mesa-oder pyramidenstumpfartigen Strukturelementen erkennbar. Die Strukturelemente erstrecken sich zwischen einer höheren Ebene, beispielsweise der ursprünglichen Bauteil-Oberfläche, und einer tieferen Ebene, die beispielsweise durch die maximale Ätztiefe definiert ist. Die Größen der Strukturelemente liegen im Mittel im Bereich von 5 bis 15 mm. Zwar sind Mikrorisse in der Quarzglas-Oberfläche nicht erkennbar. Es hat sich aber gezeigt, daß eine so gestaltete Oberfläche für eine feste Haftung von dicken CVD-Schichten nicht geeignet ist.

Aus EP-A 0 444 809 sind in Bezug auf das Ätzen einer optischen Faser aus Quarzglas verschiedene Ätzlösungen bekannt, die zu einer texturierten, mattierten Faseroberfläche führen mit verbesserter Haftfestigkeit für darauf abzuscheidende Metallisierungsschichten. Eine nähere Beschreibung der Oberflächenstruktur auf der dünnen optischen Faser ist in diesem Stand der Technik nicht enthalten.

Weiterhin wird in der japanischen Veröffentlichung JP 4-152515 ein doppelwandiger, druckreduzierter Quarzglasreaktor zur CVD-Beschichtung von Halbleitersubstraten offenbart, der auf der Innenseite seines Prozess-Rohres einen rauhen Film aufweist mit einer Unebenheit im Bereich von 10µm bis 500µm. Durch diese rauhe Oberflächenstruktur soll ein geringeres Verschmutzungsrisiko durch Abblättern der CVD-Schicht auf das zu behandelnde Halbleitersubstrats erreicht werden.

Darüber hinaus ist auch aus EP-A 0 763 504 ein druckreduzierter Quarzglasreaktor zur CVD-Beschichtung von Halbleitersubstraten bekannt. Hierbei wird durch Ätzung mit einer aus Wasser, HF, Ammoniumfluorid und Essigsäure bestehenden Ätzlösung eine feinstrukturierte Oberfläche mit eine mittleren Rauhtiefe von nur 0,03 µm bis 2 µm hergestellt. Um mit dieser Reaktoroberfläche die Abgabe von Verunreinigungen an die zu behandelnden Halbleiterbauteile zu reduzieren, wird auf die Bauteiloberfläche zusätzlich ein dünner Film eines Copolymerharzes aufgetragen.

Der vorliegenden Erfindung liegt die Aufgabe zugrunde, ein Bauteil aus Quarzglas mit einer für die Haftung von CVD-Schichten besonders geeigneten, rauhen Oberfläche anzugeben.

Diese Aufgabe wird ausgehend von dem oben genannten Quarzglas-Bauteil erfindungsgemäß dadurch gelöst, daß die mittlere Rauhtiefe Rₐ der Oberfläche zwischen 0,1 µm und 10 µm, und die Größe der Projektion der Strukturelemente auf die erste Ebene bei einem Mittelwert im Bereich zwischen 30 µm und 180 µm liegt.

Es hat sich gezeigt, daß die mittlere Rauhtiefe der Oberfläche und insbesondere die mittlere Größe der Strukturelemente für ein festes Anhaften von CVD-Schichten entscheidend ist. Optimale Ergebnisse werden bei einer mittleren Rauhtiefe Rₐ im Bereich zwischen 0,1 und 10 µm erhalten. Der Wert für die Rauhtiefe Rₐ wird entsprechend DIN 4768 ermittelt.

Wesentlich ist, daß neben einer mittleren Rauhtiefe der Oberfläche in dem oben genannten Bereich die Größe der Strukturelemente in der Projektion auf die erste, obere Ebene bei einem Mittelwert im Bereich zwischen 30 µm und 180 µm liegt. Die Größe der Strukturelemente wird anhand einer Draufsicht auf die Oberfläche ermittelt. Aus der Draufsicht ist erkennbar, daß die Strukturelemente, nur durch Begrenzungslinien voneinander getrennt, unmittelbar aneinandergrenzen. Die Begrenzungslinien sind aufgrund der erhabenen Ausbildung der Strukturelemente leicht zu erkennen. Als Größe der Strukturelemente wird der längste Abstand zwischen zwei sich gegenüberliegenden Begrenzungslinien aufgefaßt. Für die Auswertung wird ein Teil der Bauteil-Oberfläche von 10 mm² berücksichtigt. Als Mittelwert der Größe wird das arithmetische Mittel der gemessenen Größen betrachtet. Strukturelemente mit einer Größe von weniger als 5 µm bleiben bei der Ermittlung der mittleren Größe unberücksichtigt.

Eine mit einer derartigen Oberflächen-Mikrostruktur gestaltetes Quarzglas-Bauteil zeichnet sich durch eine hervorragende Haftung von CVD-Schichten aus, insbesondere auch von solchen CVD-Schichten, die in einem Verfahren bei erhöhter Temperatur abgeschieden werden. Dieser Effekt ist durch die besondere Art der Rauhigkeit der Oberfläche erklärbar, die zu einer günstigen Spannungsverteilung zwischen dem Quarzglas und dem CVD-Schichtmaterial beiträgt. Die Mikrostruktur der Oberfläche führt zu einer dreidimensionalen Verteilung der Spannung. Hierzu ist es erforderlich, daß die Strukturelemente aus im wesentlichen ebenen Flächenelementen facettenartig zusammengesetzt sind und daß sie eine mittlere Größe aufweisen, die 180 µm nicht übersteigt. Dadurch kommt es zu einer Dichte und einer Verteilung der Strukturelemente und der sie bildenden Decken- und Seitenflächen, die eine geeignete Verteilung der Spannung ermöglicht. Bei einer mittleren Größe der Strukturelemente von unterhalb 30 µm wird dieser Effekt nicht mehr beobachtet.

Im Sinne der Erfindung wird unter einer planen Deckfläche auch eine Deckfläche mit einer Wölbung verstanden, wie sie sich beispielsweise nach einem Ätzabtrag auf den ungeätzten Bereichen der Zylindermantelfläche eines rohr- oder stabförmigen Quarzglas-Bauteiles einstellt. Bei der Erzeugung der Strukturelemente durch Ätzen kann die obere Ebene durch die Oberfläche ungeätzter Bereiche definiert sein, oder durch die Oberfläche der Bereiche mit dem geringsten Ätzabtrag.

Vorteilhafterweise beträgt die mittlere Rauhtiefe Rₐ der Oberfläche zwischen 1 µm und 5 µm, und die Größe der Projektion der Strukturelemente auf die erste Ebene liegt bei einem Mittelwert im Bereich zwischen 50 µm und 100 µm.

Besonders bewährt hat sich ein Bauteil, bei dem mindestens ein Teil der Seitenflächen unter Ausbildung von Stufenelementen angeordnet ist. Ein Stufenelement ergibt sich durch eine paarweise Aneinanderreihung von Seitenflächen, wovon die eine Seitenfläche parallel zur Deckfläche oder in einem kleinen Winkel dazu, und die daran angrenzende Seitenfläche in einem größeren Winkel zur Deckfläche verläuft. Die Einhaltung eines rechten Winkels zwischen den benachbarten Seitenflächen ist nicht erforderlich. Eine stufige Ausbildung der seitlichen Begrenzungsfläche des Strukturelementes ergibt sich durch eine Aneinanderreihung einer Vielzahl von Stufenelementen. Eine derartige stufige Ausbildung von seitlichen Begrenzungsflächen trägt zu einem Spannungsabbau durch dreidimensionale Spannungsverteilung zusätzlich bei. Der Effekt ist bereits feststellbar, wenn eine derartige stufenweise Ausbildung und Anordnung der Seitenflächen bei einigen der Strukturelemente vorhanden ist. Dabei ist es nicht erforderlich, daß alle Stufenelemente einer seitlichen Begrenzungswand die gleichen geometrischen Abmessungen haben. Einen besonders deutlichen Effekt in Bezug auf die Haftfestigkeit von CVD-Schichten zeigen Stufenelemente mit einer Stufentiefe im Bereich von 0,5 µm bis 5 µm.

Es wird eine Ausführungsform des Quarzglas-Bauteils bevorzugt, bei dem in der zweiten Ebene zwischen benachbarten Strukturelementen eine Furche ausgebildet ist, die eine Breite von mindestens 1 µm aufweist. Derartige Furchen, die zwischen den Erhebungen benachbarter Strukturelemente ausgebildet sind, haben sich im Hinblick auf eine feste Haftung von CVD-Schichten als besonders vorteilhaft erwiesen. Unter der Breite wird dabei die mittlere Breite der Furche über den Längenabschnitt verstanden, in sie jeweils zwei benachbarte Strukturelemente voneinander trennt. Die Grundfläche der Furche kann eben oder gewölbt ausgebildet sein.

Eine Aneinanderreihung von Grübchen in einer Furche hat sich im Hinblick auf die Haftfestigkeit der CVD-Schicht als vorteilhaft erwiesen. Derartige Grübchen in einer Fruche können beispielsweise bei einem nachträglichen Ätzen des erfindungsgemäß strukturierten Quarzglas-Bauteiles in flußsäurehaltiger Ätzlösung ausgebildet werden.

Besonders bewährt hat sich ein Quarzglasbauteil, bei dem die Strukturelemente mit scharfen Kanten oder Ecken ausgebildet sind. Derartige Kanten und Ecken weisen beispielsweise Hinterschneidungen auf, an denen die am Bauteil anhaftende CVD-Schicht einhaken kann.

Nachfolgend wird die Erfindung anhand von Ausführungsbeispielen und anhand der Patentzeichnung näher erläutert. In der Patentzeichnung zeigen im einzelnen:
- **Figur 1**: eine schematische Darstellung eines Querschnittes durch ein erfindungsgemäßes Quarzglas-Bauteil in einer Ansicht senkrecht zur Oberfläche,
- **Figur 2**: eine rasterelektronenmikroskopische Aufnahme einer Oberfläche eines erfindungsgemäßen Bauteiles in einer 100-fachen Vergrößerung und
- **Figur 3**: den in Figur 2 markierten Ausschnitt "A" in 500-facher Vergrößerung.

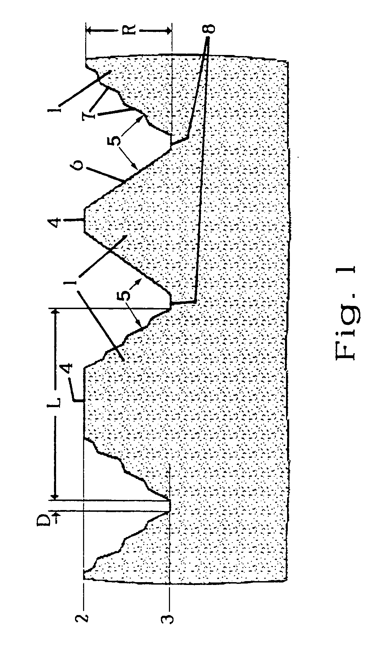

In **Figur 1** sind Strukturelemente im Sinne dieser Erfindung als Erhebungen 1 schematisch dargestellt. Die Erhebungen 1 erstrecken sich zwischen einer ersten, oberen Ebene 2 und einer zweiten, unteren Ebene 3. Im Querschnitt sind die Erhebungen 1 kegelstumpfartig ausgebildet. Sie weisen eine plane Deckfläche 4 auf, die innerhalb der oberen Ebene 2 verläuft. Die Deckfläche 4 wird von Seitenwänden begrenzt, denen in Figur 1 insgesamt die Bezugsziffer 5 zugeordnet ist. Die Seitenwände 5 sind teilweise als glatte Begrenzungsflächen 6 ausgebildet, oder sie sind aus einzelnen Stufenelementen 7 stufenförmig zusammengesetzt. Die einzelnen Stufenelemente 7 unterscheiden sich in ihrer Form voneinander. Die Seitenwände 5 benachbarter Erhebungen 1 grenzen nicht unmittelbar aneinander, sondern zwischen ihnen verläuft jeweils ein Graben 8 mit ebener Grundfläche. Die Grundfläche der Gräben 8 definiert dabei die untere Ebene 3. Durch den Graben 8 sind benachbarte Erhebungen 1 voneinander getrennt.

Die Abmessung zur Ermittlung der Größe der Erhebungen 1 ist in Figur 1 mit "L" bezeichnet. Die mittlere Grabenweite ergibt sich aus der Abmessung "D". Für die Ermittlung der Oberflächenrauhigkeit wird der Abstand "R" zwischen der oberen Ebene 2 und der unteren Ebene 3 an mehreren Stellen gemessen und daraus der Mittelwert Rₐ nach DIN 4768 berechnet.

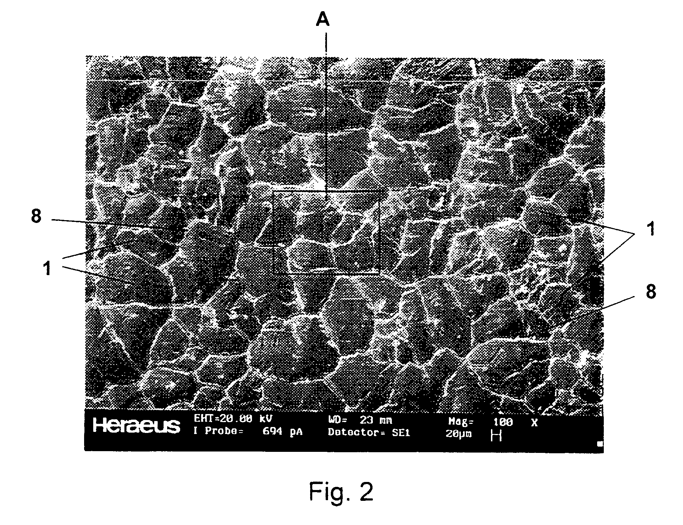

Aus der rasterelektronenmikroskopischen Aufnahme gemäß **Figur 2** ist ersichtlich, daß die Oberfläche eines erfindungsgemäßen Quarzglas-Bauteils durch eine Vielzahl unregelmäßiger Erhebungen 1 bestimmt wird, die sich durch scharfe Ecken und Kanten auszeichnen und die durch Gräben 8 voneinander getrennt sind. Die Erhebungen 1 erscheinen in der Aufnahme als dunkle Flächen, die Gräben 8 als helle Begrenzugslinien. Bei dem konkreten Ausführungsbeispiel ergibt sich eine mittlere Größe der Erhebungen 1 von ca. 100 µm. Der Wert Rₐ beträgt bei der in Figur 2 dargestellten Oberfläche ca. 2 µm.

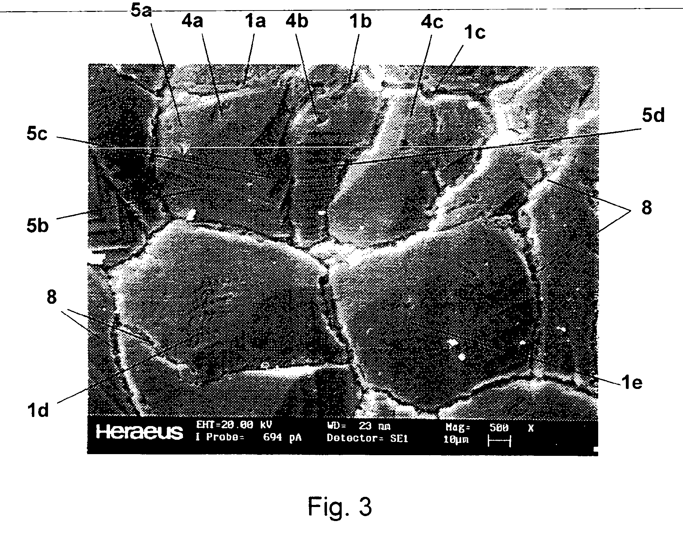

Eine Vergrößerung des Ausschnittes "A" der Aufnahme wird in **Figur 3** gezeigt. Daraus sind Details der Oberflächen-Mikrostruktur des erfindungsgemäßen Quarzglas-Bauteils zu erkennen, die nachfolgend näher erläutert werden.

In der Aufnahme sind im wesentlichen fünf unregelmäßige, pyramidenstumpfartige Erhebungen zu erkennen, die mit den Bezugsziffern 1a bis 1e gekennzeichnet sind. Beispielsweise weist die Erhebung 1a eine ausgeprägte Deckfläche 4a in Form eines Polygons auf, die von schräg nach unten verlaufenden Seitenwänden 5a, 5b, 5c begrenzt ist. Die Seitenwände 5a, 5b, 5c sind stufig ausgebildet. Die stufige Ausbildung ist insbesondere auch in der mit 5d bezeichneten Seitenwand gut zu erkennen. Die Tiefen der einzelnen Stufen bei der Seitenwand 5d sind nicht einheitlich; im Mittel beträgt die Tiefe ca. 1 µm. Die Höhe der einzelnen Stufen variiert ebenfalls.

Die einzelnen Erhebungen 1a bis 1e sind durch Gräben 8 voneinander getrennt. Die Gräben 8 haben im Mittel eine Breite "D" um 2 µm. Ihre Grundfläche ist im Ausführungsbeispiel nicht eben, sondern aufgrund einer Vielzahl aneinandergrenzender, kleiner Grübchen mit Durchmessern von weniger als 1 µm unregelmäßig gestaltet.

Die dargestellte Mikrostruktur der Bauteil-Oberfläche bietet einer darauf abgeschiedenen CVD-Schicht eine Vielzahl von Haftstellen. Dies wird gewährleistet, einerseits durch die oben angegebene mittlere Oberflächenrauhigkeit, die im wesentlichen durch die Höhen "R" der jeweiligen Erhebungen bestimmt wird, und andererseits durch deren laterale Abmessungen "L". Die Dichte und Verteilung der Erhöhungen spiegelt sich ebenfalls im Wert für die mittlere Oberflächenrauhigkeit Rₐ wider.

Im Vergleich zu dem aus dem Stand der Technik bekannten Bauteil konnten auf dem erfindungsgemäßen Quarzglas-Bauteil beispielsweise in einem CVD-Verfahren bei Temperaturen um 600°C fünf- bis zehnfach dickere Siliziumnitrid-Schichten abgelagert werden, ohne daß ein Abblättern der Schichten beobachtet wurde. Die Lebensdauer des erfindungsgemßen Bauteils ist entsprechend länger.

### Nachfolgend wird ein Verfahren zur Herstellung des erfindungsgemäßen Bauteils erläutert:

Eine vorab flammenpolierte Quarzglashorde für die Halterung von Silizium-Halbleiterscheiben wird in Alkohollösung und anschließend in flußsäurehaltiger Ätzlösung gereinigt. Eine saubere und homogene Oberfläche trägt zur Erzeugung einer gleichmäßigen Rauhigkeit und der oben erläuterten feinkörnigen Mikrostruktur über die gesamte Bauteil-Oberfläche bei.

Es wird eine Ätzlösung mit der nachfolgend angegebenen Zusammensetzung hergestellt:
23,6 Gew.-% HF (eingewogen als 50%ige HF-Lösung),
17,4 Gew.-% Ammoniumfluorid (eingewogen als Feststoff)
35,4 Gew.-% Essigsäure (eingewogen als 100%ige Essigsäure; Eisessig)
und 23,6 Gew.-% Wasser.

Die Ätzlösung wird durch einstündiges Ruhenlassen stabilisiert. Auch die Stabilisierung der Ätzlösung trägt zur Erzeugung einer gleichmäßigen Rauhigkeit und der oben erläuterten feinkörnigen Mikrostruktur über die gesamte Bauteil-Oberfläche bei.

Die Horde wird auf ca. 15°C temperiert. Anschließend wird die Quarzglashorde in Ätzlösung eingetaucht. Um einen gleichmäßigen Ätzangriff zu erreichen und Ablagerungen auf der Horden-Oberfläche zu verhindern, erfolgt der Eintauchvorgang möglichst rasch.

Bei einer Temperatur der Ätzlösung von 15°C beträgt die Behandlungsdauer 60 Minuten. Anschließend wird die Horde 10 Minuten lang in 5-%iger Flußsäurelösung nachgereinigt. Nach diesem Ätz- und Reinigungsprozeß weist die Oberfläche die in den Figuren 2 und 3 gezeigte Mikrostruktur mit einer mittleren Rauhtiefe Rₐ von 2 µm auf.

Horde und Ätzlösung können auch auf andere Temperaturen, beispielsweise auf ca. 20°C temperiert werden. Die Zusammensetzung der Ätzlösung ist gegebenenfalls anzupassen. Bei höheren Temperaturen sind stärker verdünnte Ätzlösungen geeignet.

Nachfolgend wird ein weiteres Verfahren zur Herstellung einer geeigneten Ätzlösung und ein Ausführungsbeispiel für die Herstellung eines erfindungsgemäßen Bauteils angegeben:
In einem kühlbaren Behälter wird zunächst eine wässrige Ammoniumfluorid-Lösung hergestellt, indem in reines Wasser Ammoniumfluorid-Pulver mit einem Gewichtsanteil von 40% eingerührt wird. Daraus wird durch Zugabe von 50 Gew.-% Flußsäure eine wässrige Basis-Ätzlösung hergestellt, die einen HF-Anteil von 13 Gew.-% und einen NH₄F-anteilvon 30 Gew.-% aufweist. Die eigentliche Ätzlösung wird erst kurz vor dem Ätzvorgang hergestellt, indem zu 40 Volumenanteilen der Basislösung 60 Volumenanteile einer Zusatzlösung gegeben werden. Die Zusatzlösung enthält Essigsäure mit einer Reinheit von 99,7 % und weist einen Siedepunkt bei 118,1 °C auf. In der so hergestellten Ätzlösung wird ein Quarzglas-Rohr 3 Stunden lang behandelt, anschließend mit reinem Wasser gewaschen und getrocknet. Das Quarzglas-Rohr ist danach mit einer facettenartig aufgerauhten Oberfläche versehen, deren mittlere Rauhtiefe Rₐ 0,6 µm beträgt, wobei die Größe der einzelnen Facetten im Mittel bei 100 µm liegt.

## Patentansprüche

1. Bauteil aus Quarzglas für die Verwendung bei der Halbleiterherstellung, mit einer rauhen Oberfläche, die durch unregelmäßige, erhabene Strukturelemente gebildet wird, die sich zwischen einer ersten, höheren Ebene und einer zweiten, tieferen Ebene erstrecken, wobei eine Vielzahl der Strukturelemente eine in der ersten Ebene verlaufende, im wesentlichen ebene Deckfläche aufweist, die allseitig facettenartig von im wesentlichen ebenen Seitenflächen begrenzt ist, die zwischen der ersten und der zweiten Ebene verlaufen, **dadurch gekennzeichnet, daß** die mittlere Rauhtiefe Rₐ der Oberfläche zwischen 0,1 µm und 10 µm, und die Größe der Projektion der Strukturelemente (1) auf die erste Ebene (2) im Mittel im Bereich zwischen 30 µm und 180 µm liegt.

2. Quarzglasbauteil nach Anspruch 1, **dadurch gekennzeichnet, daß** die mittlere Rauhtiefe Rₐ der Oberfläche zwischen 1 µm und 5 µm, und die Größe der Projektion der Strukturelemente (1) auf die erste Ebene (2) bei einem Mittelwert im Bereich zwischen 50 µm und 100 µm liegt.

3. Quarzglasbauteil nach Anspruch 1 oder 2, **dadurch gekennzeichnet, daß** mindestens ein Teil der Seitenflächen (5) unter Ausbildung von Stufenelementen (7) angeordnet ist.

4. Quarzglasbauteil nach Anspruch 3, **dadurch gekennzeichnet, daß** die Stufenelemente (7) Stufentiefen im Bereich von 0,5 µm bis 5 µm aufweisen

5. Quarzglasbauteil nach einem der vorhergehenden Ansprüche, **dadurch gekennzeichnet, daß** zwischen benachbarten Strukturelementen (1) eine Furche (8) ausgebildet ist, die eine Breite von mindestens 1 µm aufweist.

6. Quarzglasbauteil nach Anspruch 5, **dadurch gekennzeichnet, daß** die Furche (8) durch Aneinanderreihung einer Vielzahl von Grübchen gebildet ist.

7. Quarzglasbauteil nach einem der vorhergehenden Ansprüche, **dadurch gekennzeichnet, daß** die Strukturelemente (1) mit scharfen Ecken oder Kanten ausgebildet sind.

## Claims

1. A quartz glass component used in the production of semiconductors, with a rough surface which is formed by irregular, raised structural elements extending between a first higher plane and a second lower plane, whereby a plurality of said structural elements has a substantially flat top surface extending in the first plane, said top surface being bounded on all sides in a facet-like manner by substantially flat side surfaces which extend between the first and second planes, **characterized in that** the average depth of surface roughness Rₐ is between 0.1 µm and 10 µm, and the magnitude of projection of the structural elements (1) to the first plane (2) has an average value between 30 µm and 180 µm.

2. The quartz glass component according to claim 1, **characterized in that** the average roughness depth Rₐ of the surface is between 1 µm and 5 µm, and the magnitude of projection of the structural elements (1) to the first plane (2) has an average value ranging between 50 µm and 100 µm.

3. The quartz glass component according to claim 1 or 2, **characterized in that** at least a part of the side surfaces (5) is arranged with formation of step elements (7).

4. The quartz glass component according to claim 3, **characterized in that** the step elements (7) have step depths in the range from 0.5 µm to 5 µm.

5. The quartz glass component according to any one of the preceding claims, **characterized in that** a groove (8) having a width of at least 1 µm is formed between adjoining structural elements (1).

6. The quartz glass component according to claim 5, **characterized in that** the groove (8) is formed by juxtaposing a plurality of dimples.

7. The quartz glass component according to any one of the preceding claims, **characterized in that** the structural elements (1) are formed with sharp corners or edges.

## Revendications

1. Composant en verre de quartz pour l'utilisation dans la fabrication de semiconducteur avec une surface rugueuse qui est formée d'éléments structurels irréguliers surélevés qui s'étendent entre un premier plan plus haut et un second plan plus bas, un grand nombre des éléments structurels présentant une surface couvrante sensiblement plane s'étendant dans le premier plan, surface qui est limitée de part et d'autres à la manière de facettes par des surfaces latérales sensiblement planes qui s'étendent entre le premier et le second plans, **caractérisé en ce que** la profondeur moyenne de rugosité Rₐ de la surface est comprise entre 0,1 µm et 10 µm et la dimension de la projection des éléments de structure (1) sur le premier plan (2) est comprise en moyenne entre 30 µm et 180 µm.

2. Composant en verre de quartz selon la revendication 1, **caractérisé en ce que** la profondeur de rugosité moyenne Rₐ de la surface est comprise entre 1 µm et 5 µm et la dimension de la projection des éléments structurels (1) sur le premier plan (2) est comprise en valeur moyenne entre 50 µm et 100 µm.

3. Composant en verre de quartz selon la revendication 1 ou 2, **caractérisé en ce qu'**au moins une partie des surfaces latérales (5) est disposée en formant des éléments étagés (7).

4. Composant en verre de quartz selon la revendication 3, **caractérisé en ce que** les éléments étagés (7) présentent des profondeurs étagées comprises entre 0,5 µm et 5 µm.

5. Composant en verre de quartz selon l'une des revendications précédentes, **caractérisé en ce qu'**entre des éléments structurels voisins (1) est réalisée une fourche (8) qui présente une largeur d'au moins 1 µm.

6. Composant en verre de quartz selon la revendication 5, **caractérisé en ce que** la fourche (8) est formée par l'alignement d'un grand nombre de piqûres.

7. Composant en verre de quartz selon l'une des revendications précédentes, **caractérisé en ce que** les éléments de structure (1) sont réalisés avec des bords ou arêtes vifs.
